# EUROPÄISCHE PATENTSCHRIFT

(11) **EP 0 698 289 B1**
(45) Veröffentlichungstag und Bekanntmachung des Hinweises auf die Patenterteilung: **26.07.2000**
(21) Anmeldenummer: 94913490.2
(22) Anmeldetag: 03.05.1994
(51) Int. Cl.: H01L 21/98, H01L 25/065

(54) **KONTAKTSTRUKTURIERUNG FÜR VERTIKALE CHIPVERBINDUNGEN**
CONTACT STRUCTURE FOR VERTICAL CHIP CONNECTIONS
STRUCTURATION DE CONTACT POUR CONNEXIONS VERTICALES A PUCES

(30) Priorität: 05.05.1993 DE 4314913
(43) Veröffentlichungstag der Anmeldung: 28.02.1996
(73) Patentinhaber: SIEMENS AKTIENGESELLSCHAFT, 80333 München (DE)
(72) Erfinder: WINNERL, Josef, D-81929 München (DE); ALSMEIER, Johann, D-81373 München (DE); NEUMÜLLER, Walter, D-80539 München (DE)
(86) Internationale Anmeldenummer: DE9400492
(87) Internationale Veröffentlichungsnummer: WO9425982

(56) Entgegenhaltungen:
- EP-A- 0 238 089
- EP-A- 0 270 067
- WO-A-92/03848
- WO-A-94/05039
- US-A- 4 394 712

## Beschreibung

Die vorliegende Erfindung betrifft Halbleiterbauelemente mit einer speziellen Kontaktstrukturierung, die für eine vertikale elektrisch leitende Verbindung von mehreren Halbleiterbauelementen vorgesehen ist. Außerdem werden zugehörige Herstellungsverfahren angegeben.

Halbleiterschaltungen werden heute in Planartechnik hergestellt. Die erreichbare Komplexität auf einem Chip ist begrenzt durch dessen Größe und die erreichbare Strukturfeinheit. Die Leistungsfähigkeit eines Systems bestehend aus mehreren miteinander verbundenen Halbleiterchips ist bei konventioneller Technik wesentlich begrenzt durch die begrenzte Zahl der möglichen Verbindungen zwischen einzelnen Chips über Anschlußkontakte (Pads), die geringe Geschwindigkeit der Signalübermittlung über solche Verbindungen zwischen verschiedenen Chips (Interface-Schaltung Pad/Leiterplatte), die bei komplexen Chips begrenzte Geschwindigkeit durch weit verzweigte Leiterbahnen und den hohen Leistungsverbrauch der Interface-Schaltungen.

Diese aufgezeigten Beschränkungen bei der Verwendung der Planartechnik lassen sich mit dreidimensionalen Techniken der Verschaltung überwinden. Die Anordnung der Funktionsebenen übereinander erlaubt eine parallele Kommunikation dieser Komponenten mit geringem Aufwand elektrisch leitender Verbindungen in einer Ebene, und außerdem werden geschwindigkeitsbegrenzende Interchip-Verbindungen vermieden.

Ein bekanntes Verfahren, dreidimensionale IC's herzustellen, beruht darauf, über einer Ebene von Bauelementen eine weitere Halbleiterschicht (z. B. Silizium) abzuscheiden und diese über ein geeignetes Verfahren (z. B. lokale Erwärmung mittels Lasers) zu rekristallisieren und darin eine weitere Bauelementeebene zu realisieren. Auch diese Technik weist wesentliche Begrenzungen auf, die durch die thermische Belastung der unteren Ebene bei der Rekristallisierung und die durch Defekte begrenzte erreichbare Ausbeute gegeben sind.

Ein alternatives Verfahren von NEC stellt die einzelnen Bauelementeebenen getrennt voneinander her. Diese Ebenen werden auf wenige µm gedünnt und mittels wafer bonding miteinander verbunden. Die elektrischen Verbindungen werden in der Weise hergestellt, daß die einzelnen Bauelementeebenen auf der Vorder- und Rückseite mit Kontakten zur Interchip-Verbindung versehen werden. Dieses Verfahren hat folgende Nachteile und Einschränkungen: Die gedünnten Scheiben müssen auf der Vorderseite und auf der Rückseite in technischen Prozessen bearbeitet werden (Lithographie mit Justierung durch die Halbleiterscheibe). Das Testen auf Funktionstüchtigkeit der einzelnen Ebenen vor dem Zusammenfügen ist dadurch erschwert, daß bei diesem Verfahren in jeder Ebene einzelne Bauelemente, aber nicht vollständige Schaltungen realisiert werden. Durch das Dünnen der Scheiben bis auf die Funktionselemente entstehen SOI-ähnliche Bauelementestrukturen, so daß keine mit Standardtechnologien (z. B. Standard-CMOS) vorgefertigten Scheiben verwendet werden können.

Aufgabe der vorliegenden Erfindung ist es, Halbleiterbauelemente mit einer für dreidimensionale Kontaktierung geeigneten, einfach herstellbaren und gegenüber bisherigen Verdrahtungen verbesserten Kontaktstrukturierung und zugehörige Herstellungsverfahren anzugeben.

Diese Aufgabe wird mit den Halbleiterbauelementen mit Kontaktstrukturierung entsprechend den Merkmalen des Anspruches 1 bzw. mit dem Verfahren mit den Merkmalen des Anspruches 5 gelöst. Weitere Ausgestaltungen ergeben sich aus den abhängigen Ansprüchen.

Bei dem erfindungsgemäßen Halbleiterbauelement weist die Kontaktstrukturierung Metallstifte auf, die mit zu kontaktierenden Bereichen einer auf der Oberseite eines Substrates angeordneten Schichtstruktur mit Funktionselementen elektrisch leitend verbunden sind und das Substrat vollständig durchbohren und die gegenüberliegende Unterseite des Substrates so weit überragen, daß eine elektrisch leitende Verbindung dieser Metallstifte mit Metallkontakten auf der Oberseite eines weiteren Halbleiterbauelementes möglich ist. Bei dem erfindungsgemäßen Halbleiterbauelement und dem zugehörigen Herstellungsverfahren können mit Standardtechnologien vorgefertigte Scheiben verwendet werden. Es sind keine Eingriffe in die üblichen Basistechnologien nötig, da die für die vertikale Verbindung nötige Modifikation der Kontaktstrukturierung in Prozeßschritten ein Schluß des Herstellungsprozesses vorgenommen werden. Die Herstellung der elektrischen Kontakte auf Vorder- und Rückseite des Bauelementes erfolgt ausschließlich durch Herstellungsverfahren, die von der Vorder- oder Oberseite des Bauelementes her vorgenommen werden. Der erfindungsgemäße Aufbau des Halbleiterbauelementes und die zugehörigen Herstellungsverfahren sind daher besonders dafür geeignet, komplexe Systeme zu realisieren mit hohem Aufwand an elektrischer Verbindung. Die einzelnen vertikal miteinander verbundenen Halbleiterebenen müssen keine reinen Bauelementeebenen sein, sondern sind vorzugsweise ganze Schaltungsebenen, die mit Standardtechnologien (z. B. CMOS, Bipolartechnik oder Speicher mit Mehrlagenverdrahtung) vorgefertigt werden können. Dadurch können die einzelnen Schaltungsebenen vor dem Zusammenfügen vertikal zueinander angeordneter erfindungsgemäßer Halbleiterbauelemente getestet werden, wodurch die Ausbeute erhöht wird, weil nur funktionsfähige Komponenten miteinander kombiniert werden. Es ist auch möglich, Sensoren oder Aktoren in der Form erfindungsgemäßer Halbleiterbauelemente herzustellen. Das erfindungsgemäße Halbleiterbauelement läßt sich besonders einfach unter Anwendung eines Verfahrens (wie z. B. CMOS) herstellen, das geringe Verlustleistung des Chips durch geringe Versorgungsspannung garantiert, planar ist (einschließlich MLV), um ein Verbinden der einzelnen Ebenen mittels wafer bonding zu ermöglichen und keine spezielle und aufwendige nachträgliche Planarisierung zu erzwingen, freie Plazierung der Inter-Layer-Verbindungen ermöglicht, über Standardverfahren der Mikroelektronik zur Herstellung der Verbindungen verfügt und ggf. die Verwendung spezieller Materialien, wie niedrig schmelzendes Metall, am Ende des Prozesses ermöglicht.

Das Herstellungsverfahren dreidimensional integrierter Chips unter Verwendung der erfindungsgemäßen Halbleiterbauelemente ist modular, d. h., daß die einzelnen Ebenen unabhängig voneinander hergestellt, getestet und dann miteinander verbunden werden können. Als Einzelebenen kommen nicht nur CMOS-Schaltungsebenen in Frage, sondern auch in anderen Technologien hergestellte Schaltungsebenen, die den oben aufgezählten Eigenschaften des verwendeten Verfahrens entsprechend aufgebaut sind (z. B. Bipolar oder Speicher wie DRAM, SRAM oder nicht flüchtige Speicher). Es ist auch möglich, zwischen den Teilschaltungsebenen Ebenen ohne aktive Komponenten als reine Verdrahtungsebenen anzuordnen. Nachfolgend werden Ausführungsbeispiele des erfindungagemäßen Halbleiterbauelementes und der zugehörigen Herstellungsverfahren beschrieben, die leicht abgewandelt und den jeweiligen speziellen Anforderungen angepaßt werden können.

Es folgt die Beschreibung der erfindungsgemäßen Bauelemente und der Herstellungsverfahren anhand der Figuren 1 bis 13.
- Fig. 1 und 2: zeigen im Ausschnitt jeweils einen Querschnitt durch zwei vertikal miteinander verbundene erfindungsgemäße Halbleiterbauelemente.
- Fig. 3 bis 7: zeigen jeweils im Ausschnitt einen Querschnitt durch ein erfindungsgemäßes Halbleiterbauelement nach verschiedenen Schritten eines zugehörigen Herstellungsverfahrens.
- Fig. 8 bis 13: zeigen jeweils Ausschnitte aus dem Querschnitt einer anderen Ausführungsform des erfindungsgemäßen Halbleiterbauelementes nach verschiedenen Schritten eines anderen zugehörigen Herstellungsverfahrens.

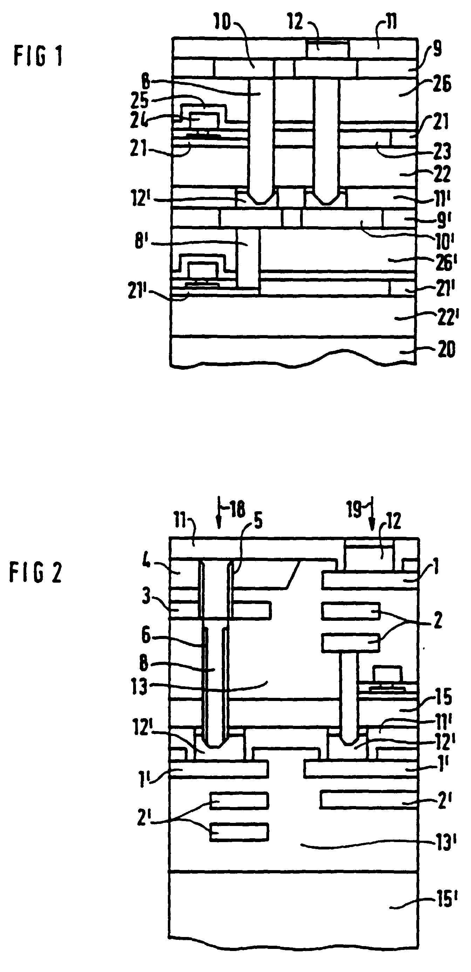

In Fig. 1 sind ausschnittweise im Querschnitt zwei vertikal zueinander angeordnete und elektrisch leitend miteinander verbundene erfindungsgemäße Halbleiterbauelemente dargestellt. Es ist im Hinblick auf das Herstellungsverfahren besonders vorteilhaft, wenn für das erfindungsgemäße Bauelement ein dreilagiges Substrat verwendet wird. Bei diesem Substrat sind zwei Halbleiterschichten durch eine Isolatorschicht voneinander getrennt. Es kann sich dabei z. B. um ein SOI-Substrat (silicon on insulator) handeln. Das erfindungsgemäße Halbleiterbauelement trägt die Funktionselemente nur auf einer Seite, der Oberseite, des Substrates. Bei Verwendung von dreilagigen Substraten wird zweckmäßig die der Oberseite gegenüberliegende Halbleiterschicht vollständig abgetragen, so daß die Isolatorschicht auf der Unterseite freigelegt ist. Damit bei der vertikalen Verbindung verschiedener Halbleiterchips die Funktionselemente nicht durch die jeweils darunter befindliche Ebene beeinträchtigt werden, kann es vorteilhaft sein, wenn die Isolatorschicht wesentlich dicker ist als bei SOI-Substraten üblich. Es kann als Isolatorschicht z. B. eine dicke Oxidschicht vorgesehen sein, wobei das dreilagige Substrat mittels wafer bonding hergestellt sein kann. Bei Verwendung eines SOI-Substrates ist von dem oberen in Fig. 1 dargestellten Halbleiterbauelement nur die Isolatorschicht 22 und die dünne Siliziumschicht 21 übrig. Die Schicht 21 kann aber auch eine auf ein herkömmliches Substrat aufgewachsene Halbleiterschichtstruktur sein. Ebenso kann die Isolatorschicht 22 eine entsprechend dickere Schicht eines mehrlagigen Substrates sein. Die unterste Halbleiterschicht des Substrates ist bei dem unteren Halbleiterbauelement in Fig. 1 ausschnittweise als Trägerscheibe 20 eines SOI-Substrates dargestellt. In der Siliziumschicht 21 (oder allgemein einer Halbleiterschichtstruktur) ist als Beispiel in diesem Ausführungsbeispiel der Figur 1 ein Feldeffekttransistor ausgebildet. Die Gate-Metallisierung 24 darüber ist ebenfalls eingezeichnet. Diese Schichtstruktur aus Halbleitermaterial kann einlagig oder mehrlagig sein. Verschiedene leitende Bereiche aus Halbleitermaterial können durch dazwischen angeordnete Isolationsbereiche 23 getrennt sein. Außerdem kann eine ein- oder ebenfalls mehrlagige Metallisierungsschichtstrukur vorhanden sein. In Fig. 1 ist der Übersichtlichkeit halber diese Metallisierungsschichtstruktur auf die Gate-Metallisierung 24 beschränkt. Zwischen dieser Schichtstruktur aus Halbleiterschicht und Metallisierungsebenen und der für die Leiterbahnen vorgesehene Ebene sind in diesem Ausführungsbeispiel eine erste Dielektrikumschicht 25 und eine zweite Dielektrikumschicht 26 angeordnet. Die Leiterbahnen 10 sind durch eine dritte Dielektrikumschicht 9 voneinander isoliert. Auf den Leiterbahnen 10 befindet sich bei dem Beispiel der Fig. 1 ein Metallkontakt 12 in einer Deckschicht 11 aus Dielektrikum. Dieser Metallkontakt 12 kann z. B. einer elektrischen Kontaktierung mit einem über diesem Bauelement angeordneten weiteren Halbleiterbauelement dienen. Wie diese Kontaktierung in vertikaler Anordnung erfolgt, ist aus der Verbindung des oberen Halbleiterbauelementes mit dem unteren Halbleiterbauelement in Fig. 1 zu entnehmen. Elektrisch leitfähige Kontaktschichten aus Halbleitermaterial, weitere Leiterbahnen oder Metallkontakte in verschiedenen Metallisierungsebenen (in dem Beispiel der Fig. 1 eine Kontaktschicht des FET aus Silizium) werden durch senkrecht zur Substratoberseite verlaufende Metallstifte 8 mit den Leiterbahnen 10 oder den Metallkontakten 12 verbunden. Diese Metallstifte 8 durchbohren das Substrat oder die von dem Substrat übrig gebliebene Isolatorschicht 22 und überragen deren Unterseite. An der Unterseite ist ein weiteres Bauelement derart angeordnet, daß beim Zusammenfügen der Chips die Enden der Metallstifte 8 elektrisch leitende Verbindungen mit den entsprechenden Metallkontakten 12' des unteren Bauelementes eingehen. Das untere Bauelement ist ähnlich dem oberen aufgebaut. Auf einem SOI-Substrat 20, 21', 22' ist in der Siliziumschicht 21' ein Feldeffekttransistor ausgebildet. Dieser Feldeffekttransistor ist elektrisch leitend mit einer Leiterbahn 10' durch einen entsprechenden Metallstift 8' verbunden. Die Ebene der Leiterbahnen 10' ist von der Ebene der Siliziumschicht 21' wieder durch Schichten aus Dielektrikum 26' getrennt. Auf den Leiterbahnen 10' sind die Metallkontakte 12' für die vertikale leitende Verbindung aufgebracht. Die Deckschicht 11' dient der Planarisierung der Oberfläche und erleichtert das vertikale Verbinden der beiden Halbleiterbauelemente. Da bei diesem Beispiel das untere Bauelement als unterstes Bauelement vorgesehen ist, ist die Trägerscheibe 20 des Substrates vorhanden und die Isolatorschicht 22' nicht von dem Metallstift 8' durchbohrt.

Analog zu der Darstellung in Fig. 1 sind in Fig. 2 ausschnittweise im Querschnitt zwei vertikal übereinandergesetzte Halbleiterbauelemente einer weiteren erfindungsgemäßen Ausführungsform dargestellt. Auf einem Substrat 15, das eine einlagige Halbleiterscheibe sein kann oder die Isolatorschicht oder Oxidschicht eines ursprünglich mehrlagigen Substrates sein kann, befindet sich eine Schichtstruktur mit Funktionselementen. Beispielhaft ist in Figur 2 eine epitaktisch aufgewachsene Schichtstruktur für einen Feldeffekttransistor mit einer darauf aufgebrachten Gate-Metallisierung eingezeichnet. Auf dem Substrat 15 und den darauf aufgebrachten oder darin integrierten Funktionselementen befindet sich eine Zwischenschicht 13 aus Dielektrikum, in der eine oder mehrere Metallisierungsebenen mit Leiterbahnen aufgebracht oder eingebettet sind. In Fig. 2 sind eine obere Metallebene 1 sowie darunter weitere Metallebenen 2 eingezeichnet. Ein das Substrat 15 durchbohrender Metallstift 8 für eine leitende Verbindung der Leiterbahn 3 mit einem vertikal darunter angeordneten Halbleiterbauelement ist von dem Substrat 15 und einem Anteil der Zwischenschicht 13 durch ein Dielektrikum 6 getrennt. Zwischen der Leiterbahn 3 und dem Metallstift 8 befindet sich eine leitende Passivierung 5, die bei der Herstellung des Metallstiftes 8 eine Kontamination des Substrates 15 mit dem Metall der Leiterbahn 3 verhindert. Auf der rechten Seite der Fig. 2 ist ein weiterer Metallstift eingezeichnet. Beide Metalstifte sind mit den Metallkontakten 12' eines darunter angeordneten weiteren Halbleiterbauelementes elektrisch leitend verbunden. Von diesem weiteren Halbleiterbauelement sind eine oberste Metallebene 1' und darunter weitere Metallebenen 2' in einer Zwischenschicht 13' eingezeichnet. Eine Deckschicht 11' aus Dielektrikum planarisiert die dem oberen Bauelement zugewandte Oberseite zwischen den Metallkontakten 12'. Die Zwischenschicht 13 des oberen Halbleiterbauelementes ist in den dargestellten Beispiel mit einer Planarisierung 4 aus Dielektrikum eingeebnet. Auf der rechten Seite (s. Pfeil 19) befindet sich auf dein oberen Halbleiterbauelement ein Metallkontakt 12 auf der obersten Metallebene 1. Die Oberfläche ist mit einer Deckschicht 11 eingeebnet. Der Metallkontakt 12 ist aus einem Metall mit niedrigeren Schmelzpunkt als das Metall der Leiterbahnen 1. Dieser Metallkontakt 12 dient einer elektrisch leitenden Verbindung mit einem darüber angeordneten Metallstift eines weiteren vertikal zu verbindenden Halbleiterbauelementes. Das Metall des Metallkontaktes 12 hat einen niedrigeren Schmelzpunkt, weil die leitende Verbindung zwischen Metallkontakt 12 und Metallstift 8 durch Erwärmen hergestellt wird und die Reaktionstemperatur dabei so niedrig bleiben soll, daß die Leiterbahnen 1, 2, 3 und restlichen Metallisierungen dadurch nicht beeinträchtigt werden. Bei Leiterbahnen aus Aluminium kann der Metallkontakt 12 z. B. AuIn sein.

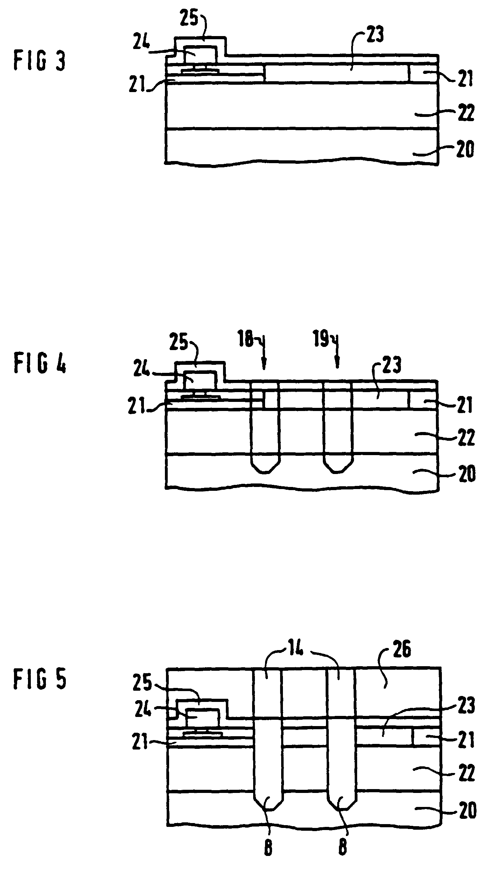

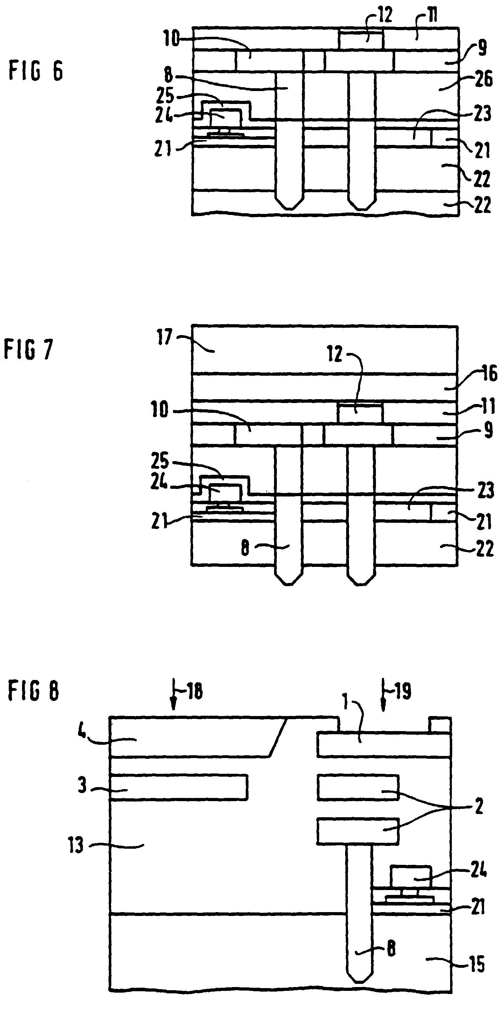

Die Details des Ausführungsbeispieles der Fig. 1 werden nachfolgend anhand der Beschreibung eines Herstellungsverfahrens näher erläutert. Als Ausgangsmaterial kann z. B. ein SOI-Substrat mit einer maximal 100 nm dicken Siliziumschicht 21 auf einer Isolatorschicht 22 (z. B. Oxid) auf einer Trägerscheibe 20 (z. B. Silizium) verwendet werden. Ein derartiges SOI-Substrat kann mit bekannten Verfahren wie Waferbonding oder SIMOX hergestellt werden. In der Siliziumschicht 21 werden die Funktionselemente (die aktiven Komponenten dieses Bauelementes) in einer Technologie für niedrige Verlustleistungen, wie z. B. SOI-CMOS für vollständig verarmte (fully depleted) MOSFET's hergestellt. Die einzelnen Funktionselemente wie z. B. diese Feldeffekttransistoren werden durch Isolationsbereiche 23 voneinander getrennt. Diese Isolationsbereiche 23 werden z. B. hergestellt, indem die Siliziumschicht 21 zwischen den Funktionselementen entfernt wird und diese Bereiche mit einem Oxid aufgefüllt wird. Es kann statt dessen eine lokale Oxidation dieser Bereiche oder eine Isolationsimplantierung vorgenommen werden. Eine erforderliche Dotierung der Funktionselemente durch Ionenimplantation, z. B. zur Einstellung der Einsatzspannung für MOSFET's, kann anschließend erfolgen. Das Dielektrikum für die Isolation des Gates bei dem MOSFET kann z. B. als thermisches Oxid mittels RTP (Rapid Thermal Processing) erzeugt werden. Erforderliche Metallisierungen, wie z. B. die in Fig. 3 eingezeichnete Gate-Metallisierung 24, aus z. B. dotiertem Polysilizium oder Metall oder Metallsilizid werden anschließend aufgebracht. Nach der Strukturierung des Gates können erneut Dotierungen eindiffundiert werden, um die Bereiche für Source und Drain mittels Ionenimplantation und nachfolgender Aktivierung (Ausheilen) herzustellen. Entsprechend werden auch andere Funktionselemente unter Anwendung der zur Verfügung stehenden Basistechnologie hergestellt. Zusätzlich können auch Halbleiterschichten epitaktisch aufgewachsen werden. In dem ersten Abschnitt des Herstellungsverfahrens wird auf diese Weise eine Schichtstruktur auf der Oberseite des Substrates hergestellt. Diese Schichtstruktur enthält die aktiven Gebiete mit den Funktionselementen und eine oder mehrere Kontaktierungsebenen. Diese Kontaktierungsebenen können z. B. durch Kontaktschichten aus Halbleitermaterial, das hoch für guten niederohmigen Metall-Halbleiter-Kontakt dotiert ist, oder durch eine Metallebene mit durch Dielektrika voneinander isolierten Leiterbahnen oder durch einzeln aufgebrachte Metallkontakte gebildet sein. Zur Vereinfachung ist bei dem Ausführungsbeispiel nur ein MOSFET in dieser Schichtstruktur eingezeichnet. Wie in Fig. 3 dargestellt, wird in einem nachfolgenden Verfahrensschritt eine erste Dielektrikumschicht 25 ganzflächig aufgebracht. In Fig. 4 sind zwei verschiedene Anordnungen für die Metallstifte der herzustellenden Kontaktstrukturierung mit einem linken Pfeil 18 und einem rechten Pfeil 19 bezeichnet. Die Bereiche für den herzustellenden Metallstift werden jeweils ausgeätzt. Dabei ist in dem rechten Beispiel (rechter Pfeil 19) in Fig. 4 das Dielektrikum der ersten Dielektrikumschicht 25, des Isolationsbereiches 23 und der Isolatorschicht 22 wegzuätzen. Es wird dann das Material der Trägerscheibe 20 (z. B. Silizium) wie eingezeichnet ausgeätzt. In dem links gezeichneten Beispiel (linker Pfeil 18) wird bei Verwendung selektiver Ätzen für das Oxid oder sonstige Material der Dielektrikumschichten und für das Silizium oder sonstige Halbleitermaterial der aktiven Gebiete und der Trägerscheibe 20 abwechselnd jeweils ein anderes Ätzmittel eingesetzt. Die Trägerscheibe 20 wird jeweils so ausgeätzt, wie für die Länge des aus dein später gedünnten Substrat ragenden Metallstiftes vorgesehen ist. Die ausgeätzten Bereiche werden dann mit Metall 8 (s. Fig. 5) gefüllt, was z. B. durch ganzflächige Abscheidung des Metalles (z. B. Wolfram) mittels CVD und Zurückätzen des Metalles auf der Oberfläche geschehen kann. Dann wird eine zweite Dielektrikumschicht 26 ganzflächig abgeschieden und planarisiert. Diese Planarisierung geschieht z. B. durch Abscheiden einer planarisierenden Hilfsschicht (wie z. B. spin-on glass) und Rückätzen oder durch chemisch-mechanisches Polieren (chemical mechanical polishing). In diese zweite Dielektrikumschicht 26 werden dann Öffnungen 14 hergestellt oberhalb des eingebrachten Metalles 8.

Die Öffnungen 14 in der zweiten Dielektrikumschicht 26 werden ebenfalls mit Metall aufgefüllt. Auf der zweiten Dielektrikumuschicht 26 wird eine Metallebene hergestellt, die z. B. Leiterbahnen oder einzelne Metallkontakte enthält. Die zweite Dielektrikumschicht 26 definiert dabei den Abstand dieser Metallebene von den aktiven Gebieten. Die Metallstifte 8 sind entsprechend bis zur Oberfläche der zweiten Dielektrikumschicht 26 verlängert. Zusätzlich zu den eingezeichneten Öffnungen 14, die den unteren Teil der herzustellenden Metallstifte 8 freilegen, können weitere Öffnungen vorgesehen sein, um einzelne Bereiche der Schichtstruktur von oben kontaktieren zu können. Da für das erfindungsgemäße Halbleiterbauelement primär die Kontaktstrukturierung mit Metallstiften 8 maßgeblich ist, sind weitere Kontaktierungen in den Figuren der Übersichtlichkeit halber nicht eingezeichnet. Auf der zweiten Dielektrikumschicht 26 werden z. B. die Leiterbahnen 10 wie in Fig. 6 gezeichnet so aufgebracht und strukturiert, daß sie wie vorgesehen mit dem Metall in den Kontaktlöchern (in diesem Beispiel die Metallstifte 8) in elektrisch leitender Verbindung sind. Zwischen den Leiterbahnen 10 wird eine dritte Dielektrikumschicht 9 zur Isolation und Planarisierung aufgebracht. Diese dritte Dielektrikumschicht 9 kann auch zuerst auf die zweite Dielektrikumschicht 26 aufgebracht und strukturiert werden. Die für die Leiterbahnen 10 vorgesehenen Bereiche werden aus der dritten Dielektrikumschicht 9 entfernt. Diese Öffnungen der dritten Dielektrikumschicht 9 werden dann wie bei der Herstellung der Metallstifte 8 mit Metall gefüllt, was auch hier durch selektive CVD-Abscheidung (z. B. von Wolfram auf einer Haftschicht) oder durch ganzflächige Abscheidung und Rückätzung mittels RIE (reactive ion etching) oder chemical mechanical polishing geschehen kann. Es können dann weitere Dielektrikumschichten aufgebracht und strukturiert werden, entsprechend der Anzahl der erforderlichen Metallisierungsebenen. Auf diese Weise können mehrere Ebenen von Leiterbahnen und Metallkontakten übereinander angeordnet werden, die jeweils durch dazwischen befindliche Dielektrikumschichten voneinander getrennt sind. Diese Dielektrikumschichten können in den Bereichen der Metallstifte 8 auch jeweils mit Metall weiter aufgefüllt werden, so daß die Metallstifte 8 bis zu weiter oben angeordneten Metallebenen verlängert werden können. Alternativ dazu ist es möglich, eine weiter oben angeordnete Metallebene mit einem Metallstift der erfindungsgemäßen Kontaktstrukturierung zu versehen, wie anhand des Ausführungsbeispieles der Figur 2 weiter unten beschrieben wird. In Fig. 6 ist zusätzlich eine Deckschicht 11 aus Dielektrikum mit einem darin befindlichen Metallkontakt 12 auf der Oberseite eingezeichnet. Dieser Metallkontakt 12 kann z. B. mit üblicher Fotomaskentechnik aufgebracht werden. Statt dessen kann die Deckschicht 11 zuerst ganzflächig aufgebracht und strukturiert werden. Das Metall des Metallkontaktes 12 wird dann durch Aufdampfen oder Sputtern aufgebracht. Dabei wird ein Metall mit einem gegenüber dem Metall der Leiterbahnen niedrigeren Schmelzpunkt aufgebracht. Der Metallkontakt 12 dient einer Verbindung mit einem entsprechenden Metallstift eines weiteren erfindungsgemäßen Bauelementes, das vertikal zu diesem Bauelement angeordnet wird. Eine Verbindung dieses weiteren Metallstiftes 8 mit dem Metallkontakt 12 geschieht durch Erwärmung. Damit die Reaktionstemperatur für diese vertikale Verbindung der Kontaktstrukturen ausreichend gering sein kann, damit die Belastung für die vorhandenen Leiterbahnen und Metallisierungen gering gehalten wird, wird für den Metallkontakt 12 ein Metall mit niedrigerem Schmelzpunkt vorgesehen. Bei Leiterbahnen aus Aluminium kann das Metall des Metallkontaktes 12 z. B. AuIn sein. Überschüssiges Metall, Material der Maske oder im Lift-off-Verfahren verwendete Materialien werden entfernt. Eine Haftschicht 16 und eine Trägerscheibe 17 werden wie in Fig. 7 gezeigt aufgebracht. Die Trägerscheibe 17 dient der Stabilisierung des Bauelementes. Das Substrat wird dann von der Rückseite gedünnt, was bei diesem Ausführungsbeispiel dadurch geschieht, daß das Halbleitermaterial (Silizium) der Trägerscheibe 20 selektiv zu dem Material (Oxid) der Isolatorschicht 22 entfernt wird. Das geschieht z. B. durch naßchemisches Rückätzen. Es ergibt sich die Struktur, die in Fig. 7 dargestellt ist. Die Halbleiterscheibe wird mit dieser Stabilisierungsschicht aus Haftschicht 16 und Trägerscheibe 17 in Chips zerteilt. Die einzelnen Chips werden auf einen vorbereiteten ersten Chip oder auf einen Stapel mehrerer Chips justiert und bei erhöhter Temperatur mit Druck aufeinander befestigt. Dabei gehen die einzelnen Metallkontakte 12 und Metallstifte 8 aufeinander je eine Verbindung ein. Es ist auch möglich, die Verbindung vor dem Zerteilen der Chips durchzuführen. In diesem Falle ist aber keine Vorselektion funktionsfähiger Chips und damit eine Ausbeuteerhöhung möglich. Bevor auf der Oberseite des Bauelementes ein weiteres Halbleiterbauelement vertikal kontaktiert wird, werden die Haftschicht 16 und die Trägerscheibe 17 darauf entfernt.

In einem Stapel mehrerer übereinander angeordneter erfindungsgemäßer Halbleiterbauelemente sind für die unterste Ebene nur Metallkontakte auf der Oberseite zu erzeugen und das Substrat braucht nicht gedünnt zu werden. Die oberste Ebene wird nur mit Metallstiften 8 versehen, d. h. die erfindungsgemäße Kontaktstrukturierung besitzt keine Metallkontakte 12 auf der Oberseite. Die dazwischen angeordneten Halbleiterbauelemente besitzen jeweils eine Kontaktstrukturierung mit Metallkontakten auf der Oberseite und aus dem gedünnten Substrat ragenden Metallstiften an der Unterseite.

Mit dem erfindungsgemäßen Verfahren lassen sich auch Halbleiterbauelemente ohne aktive Komponenten, d. h. ohne Funkionselemente, realisieren. Derartige Halbleiterbauelemente dienen dann ausschließlich der leitenden Verbindung zwischen vertikal zueinander angeordneten weiteren Bauelementen. Es sind auch Kombinationen mit weiteren Technologien wie die Technologien zur Herstellung von Bipolartransistoren und Speichern möglich. Zur Herstellung entsprechender Bauelemente sind Schichtstrukturen für diese entsprechenden Bauelemente zu realisieren und dann mit der erfindungsgemäßen Kontaktstrukturierung wie beschrieben zu versehen.

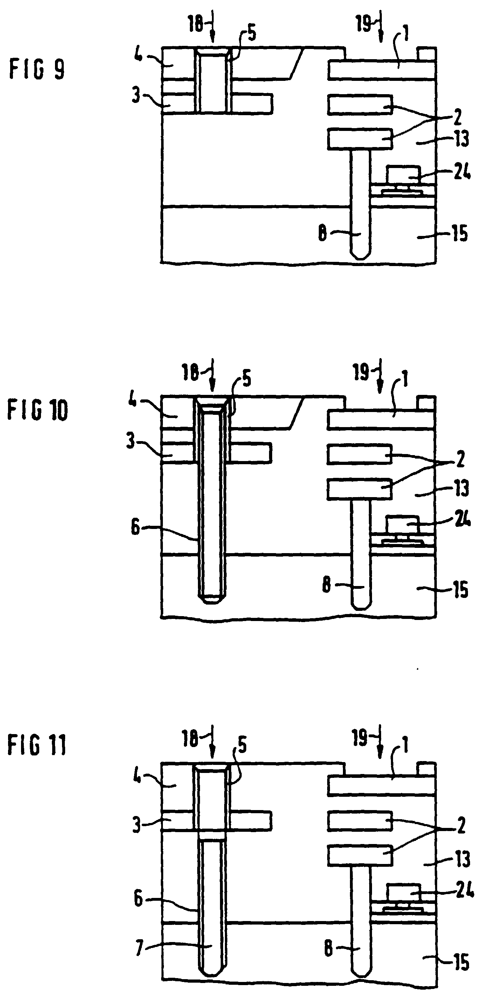

Bei dem Ausführungsbeispiel der Figur 2 wird von einem Substrat mit einer Schichtstruktur und z. B. mehreren Metallisierungsebenen (z. B. CMOS mit Merhlagenverdrahtung) und mit Passivierung (z. B. Oxid, Nitrid), bei dem die Passivierung über Testpads geöffnet ist, um eine Selektion zur Ausbeuteerhöhung vornehmen zu können, ausgegangen. In Fig. 8 ist als Beispiel auf dem Substrat 15 eine Schichtfolge 21 aus Halbleitermaterial zur Ausbildung eines FET mit Gate-Metallisierung 24 eingezeichnet. In einer Zwischenschicht 13, die mehrlagig sein kann, ist mindestens eine Metallisierungsebene ausgebildet. In Fig. 8 befindet sich eine oberste Metallebene 1 über weiteren Metallebenen 2. Es kann sich um einzelne Kontakte oder Leiterbahnen handeln. Eine untere dieser weiteren Metallebenen 2 ist bereits mit einem Metallstift 8 der erfindungsgemäßen Kontaktstrukturierung versehen. Dieser Metallstift 8 kann z. B. wie in dem vorhergehenden Ausführungsbeispiel hergestellt sein. Bei dem jetzt beschriebenen Herstellungsverfahren wird ein weiterer Metallstift nachträglich hergestellt, mit dem eine bereits vorhandene noch zu kontaktierende Metallebene 3 in die erfindungsgemäße Kontaktstrukturierung mit einbezogen wird. Falls die Oberfläche des Bauelementes keine ausreichende Planarität aufweist, wird auf die Zwischenschicht 13 eine Planarisierung 4 aus Dielektrikum (z. B. mittels PECVD abgeschiedenes Oxid) aufgebracht. Ggf. ist dazu eine planarisierende Rückätzung erforderlich. Ausgehend von der Struktur der Fig. 8 wird auf der linken Seite (Pfeil 18) der Metallstift 8 für die vertikale Kontaktierung hergestellt. Dazu wird eine Maske z. B. in Fototechnik aufgebracht und die Zwischenschicht 13 ggf. einschließlich der Passivierung 4 innerhalb der Maskenöffnung selektiv zu dem Metall der zu kontaktierenden Metallebene 3 entfernt. Das Metall wird dann selektiv zu dein Material der Zwischenschicht 13 ebenfalls geätzt. Man erhält so den oberen Teil des für den Metallstift vorgesehenen zylindrischen Bereiches. Dessen Innenseite wird mit einer Passivierung 5 (s. Fig. 9) versehen (z. B. elektrisch leitend dotiertes Polysilizium), um in nachfolgenden Verfahrensschritten das Halbleitermaterial (Silizium) des Substrates 15 gegen eine Kontamination mit Metall aus der zu kontaktierenden Metallebene 3 zu schützen. Die Passivierung 5 wird auf der Oberfläche der Zwischenschicht 13 bzw. der Planarisierung 4 und auf dem Boden des geätzten Bereiches durch anisotrope Ätzung entfernt. Das Material (z. B. Oxid) der Zwischenschicht 13 wird anisotrop und selektiv zu dem Silizium des Substrates 15 bis zu der Oberseite des Substrates 15 geätzt. Danach erfolgt die Ätzung des Substrates 15 bis aus eine definierte Tiefe, die sich aus der vorgesehenen Restdicke des Substrates 15 und der Länge des aus der Unterseite des Substrates später herausragenden Anteiles des Metallstiftes ergibt. Wie in Fig. 10 dargestellt, wird in die geätzte Öffnung ein Dielektrikum 6 abgeschieden (z. B. Oxid mittels PECVD) und anisotrop auf der Oberfläche und auf dem Boden des ausgeätzten Bereiches entfernt. Dieses Dielektrikum 6 wird dann entsprechend Fig. 11 im Bereich der zu kontaktierenden Metallebene 3 entfernt. Das kann z. B. dadurch erfolgen, daß die geätzte Öffnung teilweise, d. h. bis zu einer Höhe unterhalb der zu kontaktierenden Metallebene 3 mit einer Maske 7 z. B. aus Lack gefüllt wird und mit einer isotropen Ätzung das Material, z. B. Oxid, dieses Dielektrikums 6 in dem oberhalb dieser Maske 7 befindlichen Bereich entfernt wird. Anschließend wird diese Maske 7 ebenfalls entfernt. Wie in Fig. 11 dargestellt befindet sich das Dielektrikum 6 im unteren Bereich der geätzten Öffnung als Isolation des herzustellenden Metallstiftes 8 gegenüber dem Material des Substrates 15 und der darauf befindlichen Schichtstruktur. Der Kontakt des Metallstiftes 8 mit der zu kontaktierenden Metallebene 3 wird durch die elektrisch leitende Passivierung 5, die von dem Dielektrikum 6 freigelegt ist, ermöglicht. Die geätzte Öffnung wird dann mit dem Metall des Metallstiftes 8 gefüllt, was z. B. durch ganzflächige Abscheidung von Wolfram mittels CVD und Zurückätzen des Wolframs auf der Oberfläche erfolgen kann.

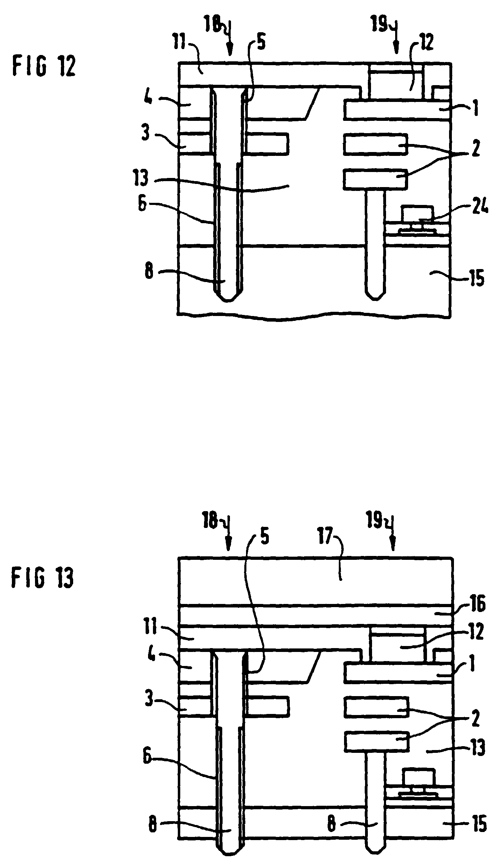

Nachdem die erfindungsgemäße Kontaktstrukturierung aus Metallstiften 8 im unteren Bereich des Bauelementes hergestellt ist, wie in Fig. 12 dargestellt, werden die Metallkontakte 12 auf der Oberseite für die vertikale Kontaktierung mit Metallstiften weiterer Bauelemente hergestellt. Die obere Metallebene 1 wird im rechten Bereich der Fig. 12 (s. Pfeil 19) mit einem derartigen Metallkontakt 12 versehen. Dazu kann z. B. eine Deckschicht 11 aus Dielektrikum ganzflächig abgeschieden und planarisiert werden. Mit den üblichen Verfahren für die Herstellung von Metallkontakten wie Fototechnik und Lift-off-Technik wird dann die Herstellung fortgesetzt. Das Material der Deckschicht 11 wird im Bereich des herzustellenden Metallkontaktes 12 entfernt und das Metall durch Aufdampfen oder Sputtern aufgebracht. Es wird wie in dem vorhergehenden Ausführungsbeispiel Metall mit relativ zu den Leiterbahnen niedrigerem Schmelzpunkt aufgebracht. Die Masken und überschüssiges Metall auf der Oberfläche werden entfernt. Die planare Oberseite kann durch Aufbringen einer Haftschicht 16 und einer Trägerscheibe 17 stabilisiert werden.

Das Substrat 15 wird dann von der Rückseite gedünnt, indem das Halbleitermaterial rückgeätzt wird, z. B. durch chemischmechanisches Polieren (CMP), bis die unteren Spitzen der Metallstifte 8 freigelegt sind. Daß dieser Zustand erreicht ist, kann z. B. daran erkannt werden, daß sich die Reibung bei den chemisch-mechanischen Polieren verändert. Das Material des Substrates 15 wird dann noch selektiv zu den Metallstiften 8 weiter zurückgeätzt, bis die Enden der Metallstifte 8 in der vorgesehenen Weise über die Unterseite des Substrates 15 hinausragen (s. Fig. 13). Auch bei diesem Ausführungsbeispiel kann dieser letzte Verfahrensschritt dadurch vereinfacht sein, daß ein mehrlagiges Substrat verwendet wird. Zwischen einer mit der Schichtstruktur versehenen oberen Halbleiterschicht und der eigentlichen Trägerscheibe aus Halbleitermaterial befindet sich eine Zwischenschicht (z. B. Oxid), bezüglich der das Halbleitermaterial (z. B. Silizium) der Trägerscheibe selektiv geätzt werden kann. Die Metallstifte 8 werden dann so weit in die Trägerscheibe hineinragend hergestellt, daß in dem letzten Verfahrensschritt nur die Trägerscheibe des Substrates vollständig und selektiv bezüglich der Zwischenschicht entfernt zu werden braucht. Statt eines SOISubstrates mit einer üblichen dünnen Isolatorschicht kann für das erfindungsgemäße Bauelement ein speziell hergestelltes mehrlagiges Substrat mit einer wesentlich dickeren Isolatorschicht verwendet werden, damit eine ausreichende Isolation der Schichtstruktur mit den Funktionselementen von den Oberflächenschichten eines vertikal darunter angeordneten weiteren Bauelementes gewährleistet ist.

Die weitere Verarbeitung des Halbleiterbauelementes, die Vereinzelung in Chips und vertikale Verbindung mit weiteren Bauelementen kann wie in dem zuerst beschriebenen Ausführungsbeispiel erfolgen. Passivierung 5 und Dielektrikum 6 auf den Seitenwänden des für den Metallstift 8 ausgeätzten Loches können auch in dem Herstellungsverfahren der ersten Ausführungsform eingesetzt werden. In diesem ersten Ausführungsbeispiel können die Metallstifte 8 ähnlich wie in dem zweiten Ausführungsbeispiel erst nach dem Aufbringen der Dielektrikumschichten und der Leiterbahnen 10 hergestellt werden. Zweckmäßigerweise erfolgt die Herstellung der oberen Metallkontakte für die Verbindung zu Metallstiften 8 weiterer Bauelemente erst zuletzt auf der obersten Metallebene. Die Metallstifte 8 können auch durch weitere obere Metallebenen hindurch hergestellt werden, wenn in dem für den Metallstift 8 vorgesehenen Bereich in diesen oberen Metallebenen keine Leiterbahnen oder einzelne Metallkontakte gekreuzt werden, sondern nur durch das entsprechende Dielektrikum dieser Schichten hindurch geätzt werden muß. Die Herstellung der erfindungsgemäßen Kontaktstrukturierung läßt sich auf diese Weise an die jeweilige Schichtstruktur der Bauelemente anpassen, und der Herstellungsprozeß kann entsprechend optimiert werden. Als Schichtstruktur im Sinne der Ansprüche ist dabei jeweils eine beliebige Struktur aus Halbleiterschichten und/oder Metallisierungsebenen mit Kontaktschichten aus leitfähig dotiertem Halbleitermaterial, Leiterbahnen und/oder einzelnen Metallkontakten zu verstehen. Die elektrisch leitenden Bereiche sind jeweils voneinander durch isolierendes Dielektrikum getrennt. Zur Vereinfachung der Herstellungstechnologie kann vorgesehen sein, daß die vertikal miteinander zu verschaltenden Halbleiterbauelemente gleichartig aufgebaut sind und die schaltungstechnische Verbindung durch die spezielle Anordnung der erfindungsgemäßen Kontaktstrukturierung erreicht wird. Jedes Bauelement enthält dann die gleichen Funktionselemente, die bei der vertikalen Verbindung aufgrund der Kontaktstrukturierung in der vorgesehenen Weise zusammengeschaltet werden. Unter einer Planarisierung oder Deckschicht ist jeweils eine oberste Dielektrikumschicht oder ein oberster Schichtanteil einer Dielektrikumschicht zu verstehen, die bzw. der die Oberseite des Bauelementes einebnet.

## Patentansprüche

1. Halbleiterbauelement mit einer Kontaktstrukturierung für vertikale Kontaktierung mit weiteren Halbleiterbauelementen und mit einem Substrat (15), das auf einer Oberseite eine Schichtstruktur aufweist,
bei dem diese Schichtstruktur mindestens eine Halbleiterschicht, eine Dielektrikumschicht und eine Metallisierungsebene umfaßt,
bei dem mindestens ein Metallstift (8) vorhanden ist, der dieses Substrat (15) senkrecht zu dieser Oberseite durchbohrt,
bei dem dieser Metallstift (8) in elektrischem Kontakt ist mit mindestens einer Kontaktschicht aus Halbleitermaterial oder einer metallischen Leiterbahn (10) in dieser Schichtstruktur, wobei der Metallstift diese Kontaktschicht oder diese Leiterbahn berührt oder wobei diese Leiterbahn auf ein Ende des Metallstiftes aufgebracht ist,
bei dem ein Anteil des Metallstiftes von einem Dielektrikum (6) umgeben ist oder eine Isolatorschicht (22) durchbohrt und bei dem dieser Metallstift (8) die der Oberseite gegenüberliegende Unterseite des Substrates (15) so weit überragt, daß er mit einem dafür vorgesehenen Metallkontakt (12') eines weiteren Halbleiterbauelementes elektrisch leitend verbunden werden kann, wenn dieses weitere Halbleiterbauelement mit diesem Metallkontakt (12') zu diesem Metallstift (8) hin an dieser Unterseite ausgerichtet wird.

2. Halbleiterbauelement nach Anspruch 1,
bei dem auf der Schichtstruktur ein Metallkontakt (12) mit niedrigerem Schmelzpunkt als dem von Leiterbahnen vorhanden ist, der für die elektrisch leitende Verbindung mit einen Metallstift an der Unterseite eines weiteren Halbleiterbauelementes vorgesehen ist.

3. Halbleiterbauelement nach Anspruch 2,
bei den mindestens ein Metallstift (8) und mindestens ein Metallkontakt (12) vorhanden sind derart, daß zwei gleichartige, mit dieser Kontaktstrukturierung versehene Halbleiterbauelemente vertikal zueinander so angeordnet werden können, daß dieser Metallstift (8) des einen Halbleiterbauelementes mit diesen Metallkontakt (12') des anderen Halbleiterbauelementes elektrisch leitend verbunden werden kann.

4. Halbleiterbauelement nach einem der Ansprüche 1 bis 3,
bei dem das Substrat eine Oxid-Schicht (22) ist und das Halbleiterbauelement auf der Schichtstruktur mit einer Haftschicht (16) und einer Trägerscheibe (17) stabilisiert ist.

5. Verfahren zur Herstellung einer Kontaktstrukturierung eines Halbleiterbauelementes, bei dem in einem ersten Schritt auf einem Substrat (15; 20, 21, 22) eine Schichtstruktur (1, 2, 3; 21, 24), die mindestens eine Halbleiterschicht, eine Dielektrikumschicht und eine Metallisierungsebene umfaßt, auf einer Oberseite soweit hergestellt wird, daß eine mit einem Metallstift zu kontaktierende Kontaktschicht aus Halbleitermaterial oder eine Leiterbahn oder ein Metallkontakt vorhanden ist,
bei dem in einem zweiten Schritt unter Verwendung einer Maske in anisotropen Ätzschritten diese Schichtstruktur und das Substrat von der Oberseite zu der der Oberseite gegenüberliegenden Unterseite hin im Bereich des herzustellenden Metallstiftes entfernt werden,
bei dem in einem dritten Schritt Metall in diesen Bereich eingebracht wird und
bei dem in einem vierten Schritt die Unterseite des Substrates (15; 20) soweit entfernt wird, daß der in dem dritten Schritt hergestellte Metallstift (8) diese Unterseite wie vorgesehen überragt.

6. Verfahren nach Anspruch 5,
bei dem in dem ersten Schritt ein Substrat aus zwei durch eine koplanar zur Oberseite angeordnete Isolatorschicht (22) getrennten Schichten (20, 21) aus Halbleitermaterial verwendet wird,
bei dem in dem zweiten Schritt der für den Metallstift vorgesehene Bereich mindestens bis in die die Unterseite des Substrates bildende Schicht (20) aus Halbleitermaterial geätzt wird und
bei dem in dem vierten Schritt diese Schicht (20) aus Halbleitermaterial vollständig entfernt wird, indem das Halbleitermaterial selektiv bezüglich dieser Isolatorschicht (22) geätzt wird.

7. Verfahren nach Anspruch 6,
bei dem das Substrat ein SOI-Substrat ist,
bei dem in dem ersten Schritt vorgesehene Funktionselemente in der dünnen Siliziumschicht dieses Substrates hergestellt werden und dann ganzflächig eine erste Dielektrikumschicht (25) aufgebracht wird,
bei dem zwischen dem dritten und dem vierten Schritt eine zweite Dielektrikumschicht (26) ganzflächig aufgebracht und planarisiert wird, unter Verwendung von Maskentechnik Öffnungen (14) in dieser zweiten Dielektrikumschicht (26) als Kontaktlöcher hergestellt werden, diese Kontaktlöcher mit Metall gefüllt werden und darauf in einer dritten Dielektrikumschicht (9) Leiterbahnen (10) oder Metallkontakte (12) hergestellt werden.

8. Verfahren nach einem der Ansprüche 5 bis 7,
bei dem ein Metallstift für die Kontaktierung einer Leiterbahn oder eines Metallkontaktes hergestellt wird, indem der zweite Schritt so ausgeführt wird, daß in einem ersten weiteren Schritt eine Planarisierung (4) aus einem Dielektrikum aufgebracht wird,
in einem zweiten weiteren Schritt unter Verwendung einer Maske der für den Metallstift vorgesehene Bereich bis einschließlich in die Leiterbahn oder den Metallkontakt hinein ausgeätzt wird,
in einem dritten weiteren Schritt die Seiten dieses ausgeätzten Bereiches mit einer Passivierung (5) versehen werden, in einem vierten weiteren Schritt der für den Metallstift vorgesehene Bereich vollständig ausgeätzt wird,
in einem fünften weiteren Schritt die Seiten des ausgeätzten Bereiches mit einem Dielektrikum (6) beschichtet werden und in einem sechsten weiteren Schritt dieses Dielektrikum (6) unter Verwendung einer Maske (7) in dem Bereich der Leiterbahn oder des Metallkontaktes entfernt wird.

9. Verfahren nach einem der Ansprüche 5 bis 8,
bei dem die Folge der Verfahrensschritte zur Herstellung eines Metallstiftes der Kontaktstrukturierung mehrmals für die Kontaktierung verschiedener Ebenen der Schichtstruktur ausgeführt wird.

## Claims

1. Semiconductor component having a contact structure for making vertical contact with further semiconductor components and having a substrate (15) which has a layer structure on a top side,
in which this layer structure comprises at least one semiconductor layer, a dielectric layer and a metallization plane,
in which at least one metal pin (8) is present, which penetrates said substrate (15) perpendicularly with respect to said top side,
in which said metal pin (8) is in electrical contact with at least one contact layer made of semiconductor material or a metallic conductor track (10) in this layer structure, the metal pin touching said contact layer or said conductor track, or said conductor track being fitted to one end of the metal pin,
in which part of the metal pin is surrounded by a dielectric (6) or penetrates an isulator layer (22), and
in which said metal pin (8) projects beyond the underside, opposite to the top side, of the substrate (15) to such an extent that it can be electrically conductively connected to a metal contact (12'), provided therefor, of a further semiconductor component if said further semiconductor component with said metal contact (12') is aligned towards said metal pin (8) on said underside.

2. Semiconductor component according to Claim 1, in which there is present on the layer structure a metal contact (12) which has a lower melting point than that of conductor tracks and is provided for the electrically conductive connection to a metal pin on the underside of a further semiconductor component.

3. Semiconductor component according to Claim 2, in which at least one metal pin (8) and at least one metal contact (12) are present, in such a way that two identical semiconductor components provided with this contact structure can be arranged vertically with respect to one another in such a way that said metal pin (8) of the one semiconductor component can be electrically conductively connected to said metal contact (12') of the other semiconductor component.

4. Semiconductor component according to one of Claims 1 to 3,
in which the substrate is an oxide layer (22) and the semiconductor component is stabilized on the layer structure with an adhesion layer (16) and a carrier wafer (17).

5. Process for producing a contact structure of a semiconductor component, in which in a first step a layer structure (1, 2, 3; 21, 24), which comprises a semiconductor layer, a dielectric layer and a metallization plane, is produced on a top side of a substrate (15; 20, 21, 22) to such an extent that a contact layer, which is made of semiconductor material and with which a metal pin is to make contact, or a conductor track or a metal contact is present,
in which in a second step, using a mask, said layer structure and the substrate are removed in anisotropic etching steps from the top side towards the underside, opposite to the top side, in the region of the metal pin to be produced,
in which in a third step metal is introduced into this region, and
in which in a fourth step the underside of the substrate (15; 20) is removed until the metal pin (8) produced in the third step projects beyond said underside as envisaged.

6. Process according to claim 5,
in which in the first step use is made of a substrate comprising two layers (20, 21) of semiconductor material which are isolated by an insulator layer (22) which is arranged to be coplanar with the top side, in which in the second step the region provided for the metal pin is etched at least as far as the layer (20) of semiconductor material forming the underside of the substrate, and
in which in the fourth step said layer (20) of semiconductor material is completely removed by etching the semiconductor material selectively with respect to said insulator layer (22).

7. Process according to Claim 6,
in which the substrate is an SOI substrate, in which in the first step envisaged functional elements are produced in the thin silicon layer of said substrate and then a first dielectric layer (25) is applied over the whole area,
in which between the third and the fourth step a second dielectric layer (26) is applied over the whole area and planarized, openings (14) are produced, using a mask technique, as contact holes in said second dielectric layer (26), said contact holes are filled with metal and then conductor tracks (10) or metal contacts (12) are produced in a third dielectric layer (9).

8. Process according to one of Claims 5 to 7,
in which a metal pin for making contact with a conductor track or a metal contact is produced by carrying out the second step in such a way that in a first further step a planarization layer (4) made of a dielectric is applied,
in a second further step the region provided for the metal pin is etched out, using a mask, right up to and including the conductor track or the metal contact,
in a third further step the sides of this etched-out region are provided with a passivation layer (5), in a fourth further step the region provided for the metal pin is etched out completely,
in a fifth further step the sides of the etched-out region are coated with a dielectric (6), and
in a sixth further step said dielectric (6) is removed, using a mask (7), in the region of the conductor track or of the metal contact.

9. Process according to one of Claims 5 to 8, in which the sequence of process steps for producing a metal pin of the contact structure is carried out repeatedly for making contact between different planes of the layer structure.

## Revendications

1. Composant à semi-conducteur, comprenant une structuration de contact pour la mise en contact verticale avec d'autres composants à semi-conducteurs, et comprenant un substrat (15) qui comporte sur le dessus une structure stratifiée, dans lequel
cette structure stratifiée comprend au moins une couche semi-conductrice, une couche diélectrique et un plan de métallisation,
il est présent au moins un ergot (8) métallique, qui transperce ce substrat (15) perpendiculairement à ce dessus,
cet ergot (8) métallique est en contact électrique avec au moins une couche de contact en matériau semi-conducteur ou une piste (10) conductrice métallique dans cette structure stratifiée, l'ergot métallique touchant cette couche de contact ou cette piste conductrice, ou cette piste conductrice étant déposée sur une extrémité de l'ergot métallique,
une partie de l'ergot métallique est entourée par un diélectrique (6) ou transperce une couche (22) isolante,
et cet ergot (8) métallique dépasse du dessous, opposé au dessus, du substrat (15) suffisamment pour pouvoir être relié en conduction électrique à un contact (12') métallique, prévu à cet effet, d'un autre composant à semi-conducteur, si cet autre composant à semi-conducteur est orienté par ce contact (12') métallique en direction de cet ergot (8) métallique sur ce dessous.

2. Composant à semi-conducteur suivant la revendication 1, dans lequel un contact (12) métallique de point de fusion plus bas que celui de pistes conductrices est présent sur la structure stratifiée et est prévu pour la connexion électroconductrice à un ergot métallique sur le dessous d'un autre composant à semi-conducteur.

3. Composant à semi-conducteur suivant la revendication 2, dans lequel au moins un ergot (8) métallique et au moins un contact (12) métallique sont présents de telle sorte que deux composants à semi-conducteurs de même type, pourvus de cette structuration de contact, peuvent être disposés verticalement l'un par rapport à l'autre de telle sorte que cet ergot (8) métallique du premier composant à semi-conducteur peut être relié en conduction électrique à ce contact (12') métallique de l'autre composant à semi-conducteur.

4. Composant à semi-conducteur suivant, l'une des revendications 1 à 3, dans lequel le substrat est une couche (22) d'oxyde et le composant à semi-conducteur est stabilisé sur la structure stratifiée par une couche (16) d'adhérence et une galette (17) porteuse.

5. Procédé de fabrication d'une structuration de contact d'un composant à semi-conducteur, suivant lequel,
lors d'une première étape, une structure (1, 2, 3 ; 21, 24) stratifiée, comprenant au moins une couche semi-conductrice, une couche diélectrique et un plan de métallisation, est réalisée sur le dessus d'un substrat (15 ; 20, 21, 22) jusqu'à ce qu'il y ait une couche de contact en matériau semi-conducteur ou une piste conductrice ou un contact métallique, à mettre en contact avec un ergot métallique,
lors d'une deuxième étape, en utilisant un masque et par attaque chimique progressive anisotrope, cette structure stratifiée et le substrat sont éliminés du dessus au dessous, opposé au dessus, dans la région de l'ergot métallique à fabriquer,
lors d'une troisième étape, on introduit du métal dans cette région,
et, lors d'une quatrième étape, le dessous du substrat (15 ; 20) est éliminé suffisamment pour que l'ergot (8) métallique fabriqué lors de la troisième étape dépasse de ce dessous comme prévu.

6. Procédé suivant la revendication 5, suivant lequel
lors de la première étape, on utilise un substrat constitué de deux couches (20, 21) en matériau semi-conducteur, séparées par une couche (22) isolante disposée coplanairement au dessus,
lors de la deuxième étape, la région prévue pour l'ergot métallique est attaquée chimiquement au moins jusque dans la couche (20) en matériau semi-conducteur formant le dessous du substrat,
et, lors de la quatrième étape, cette couche (20) en matériau semi-conducteur est totalement éliminée, par le fait que le matériau semi-conducteur subit une attaque chimique sélective par rapport à cette couche (22) isolante.

7. Procédé suivant la revendication 6, suivant lequel
le substrat est un substrat SOI (silicium sur l'isolant),
les éléments fonctionnels prévus dans la première étape sont réalisés dans la mince couche de silicium de ce substrat, puis une première couche (25) diélectrique est déposée sur toute la surface,
entre la troisième et la quatrième étape, une deuxième couche (26) diélectrique est déposée sur toute la surface et rendue plane, des ouvertures (14) sont réalisées comme trous de contact dans cette deuxième couche (26) diélectrique en utilisant la technique de masquage, ces trous de contact sont remplis de métal, et on réalise au-dessus, dans une troisième couche (9) diélectrique, des pistes (10) conductrices ou des contacts (12) métalliques.

8. Procédé suivant l'une des revendications 5 à 7, suivant lequel on réalise un ergot métallique, pour la mise en contact d'une piste conductrice ou d'un contact métallique, par le fait que la deuxième étape est exécutée de telle sorte que, lors d'une autre première étape, on appose un moyen (4) de planage constitué d'un diélectrique,
lors d'une autre deuxième étape, en utilisant un masque, on attaque chimiquement la région prévue pour l'ergot métallique jusque et y compris dans la piste conductrice ou le contact métallique,
lors d'une autre troisième étape, les côtés de cette région attaquée chimiquement sont pourvus d'une passivation (5),
lors d'une autre quatrième étape, la région prévue pour l'ergot métallique est totalement éliminée par attaque chimique,
lors d'une autre cinquième étape, les côtés de la région éliminée par attaque chimique sont revêtus d'un diélectrique (6),
et, lors d'une autre sixième étape, ce diélectrique (6) est, en utilisant un masque (7), éliminé dans la région de la piste conductrice ou du contact métallique.

9. Procédé suivant l'une des revendications 5 à 8,
suivant lequel la succession des étapes du procédé de fabrication d'un ergot métallique de la structuration de contact est répétée plusieurs fois pour la mise en contact de différents plans de la structure stratifiée.
